# EUROPEAN PATENT APPLICATION

(11) **EP 1 765 002 A2**
(43) Date of publication of application: **21.03.2007**
(21) Application number: 06254623.9
(22) Date of filing: 05.09.2006
(51) Int. Cl.: H04N 5/225

(54) **Coated wafer level camera modules and associated methods**

(30) Priority: 07.09.2005 US 220452
(71) Applicant: OmniVision Technologies, Inc., Sunnyvale, California 94089 (US)
(72) Inventor: Hiltunen, Jari, 38460 Mouhijarvi (FI)
(74) Representative: Hackney, Nigel John

(57) **Abstract**

Coated wafer level camera modules and associated methods are disclosed. One aspect of the invention is directed toward a wafer level camera module that includes a die having multiple image sensor integrated circuits. The module can further include a coating covering at least a portion of the die. The coating can be configured to provide at least a partial shield against selected types of electromagnetic energy. The module can still further include multiple contacts positioned to electrically couple the integrated circuits to a support. In certain embodiments, the selected types of electromagnetic energy can include one or more selected frequencies of light.

## Description

The present invention relates to coated wafer level camera modules and associated methods.

Image sensors have become ubiquitous. They are widely used in digital still cameras, cellular phones, security cameras, medical equipment, automobiles, and other applications. The technology used to manufacture image sensors, and in particular CMOS and CCD image sensors, has continued to advance at a great pace. For example, the demands of higher resolution, lower power consumption, and smaller devices have encouraged the further miniaturization and integration of the image sensor and associated elements.

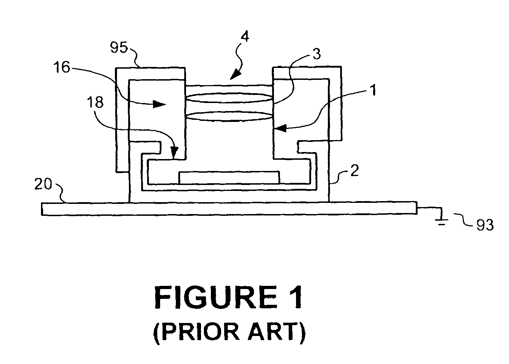

Many microelectronic camera modules require shielding from various forms of electromagnetic energy. Current systems use metal boxes, placed over the camera modules and connected to a ground to provide shielding against electromagnetic radiation. For example, Figure 1 is a partially schematic cross-sectional illustration of a camera module 1 mounted to a printed circuit board 20 with a metal box 95 placed around the camera module 1 in accordance with the prior art. The camera module 1 includes a sensor portion 18, a lens portion 16, and a housing 3. The housing 3 is configured to generally prevent light from entering the camera module 1 except through an opening 4 in the housing 3. The camera module 1 is mounted on a socket 2. The metal box 95 is positioned around the camera module 1 and also carried by the socket 2. The socket is connected to the printed circuit board 20, connecting the camera module 1 to the circuit board 20. Additionally, the metal box 95 is connected to a ground 93 via the socket 2 and the printed circuit board 20. Accordingly, the metal box 95 can shield the camera module 1 from selected types of electromagnetic radiation.

During the production of the assembly shown in Figure 1, the use of the socket 2 and the metal box 95 can complicate the production process. Additionally, the metal box 95 and socket 2 can increase the overall weight and size of the device, both of which can be undesirable.

Aspects of the present invention are directed toward coated wafer level camera modules and associated methods. Certain aspects of the invention are directed toward a wafer level camera module that includes a die having multiple image sensor integrated circuits. The module can further include at least one grounding pad and a conductive coating covering at least a portion of the die. The coating can be electrically coupled to the at least one grounding pad. The module can still further include multiple contacts that are positioned to electrically couple the integrated circuits and the at least one grounding pad to a support. In still other embodiments, the conductive coating can be configured to provide at least a partial shield against selected types of electromagnetic energy when the at least one grounding pad is electrically coupled to the support. In yet other embodiments, the coating can be configured to provide at least a partial shield against one or more selected frequencies of light.

Other aspects of the invention are directed toward a wafer level camera module that includes a die having multiple image sensor integrated circuits. The module can further include a coating covering at least a portion of the die. The coating can be configured to provide at least a partial shield against selected types of electromagnetic energy. The module can still further include multiple contacts positioned to electrically couple the integrated circuits to a support. In other embodiments, the selected types of electromagnetic energy can include one or more selected frequencies of light.

Still other aspects of the invention are directed toward a method for making a coated wafer level camera module that includes providing a wafer level camera module having a die with multiple image sensor integrated circuits, at least one grounding pad, and multiple contacts positioned to electrically couple the integrated circuits and the at least one grounding pad to a support. The method can further include applying a conductive coating to at least a portion of the die. The coating can be electrically coupled to the at least one grounding pad.

### BRIEF DESCRIPTION OF THE DRAWINGS

Figure 1 is a partially schematic cross-sectional illustration of a camera module mounted to a printed circuit board with a metal box placed over the camera module and connected to a ground via the printed circuit board in accordance with the prior art.

Figure 2A is a partially schematic side view of a wafer level camera module in accordance with embodiments of the present invention.

Figure 2B is a partially schematic top view of the wafer level camera module shown in Figure 2A.

Figure 2C is a partially schematic bottom view of the wafer level camera module shown in Figure 2A.

Figure 3 is a partially schematic illustration of the wafer level camera module shown in Figure 2A positioned in a chamber to receive a coating in accordance with embodiments of the present invention.

Figure 4A is a partially schematic side view of the wafer level camera module shown in Figure 2A after having received a coating in accordance with embodiments of the present invention.

Figure 4B is a partially schematic top view of the wafer level camera module shown in Figure 4A.

Figure 4C is a partially schematic bottom view of the wafer level camera module shown in Figure 4A.

Figure 5 is a partially schematic illustration of the coated wafer level camera module, shown in Figure 4A, coupled to a support in accordance with embodiments of the present invention.

In the following description, numerous specific details are provided in order to give a thorough understanding of embodiments of the invention. One skilled in the relevant art will recognize, however, that the invention may be practiced without one or more of the specific details, or with other methods, components, materials, etc. In other instances, well known structures, materials, or operations are not shown or described in order to avoid obscuring aspects of the invention.

References throughout the specification to "one embodiment" or "an embodiment" means that a particular feature, structure, or characteristic described in connection with the embodiment is included in at least one embodiment of the present invention. Thus, the appearances of the phrase "in one embodiment" or "in an embodiment" in various places throughout the specification are not necessarily all referring to the same embodiment. Furthermore, the particular features, structures, or characteristics may be combined in any suitable manner in one or more embodiments.

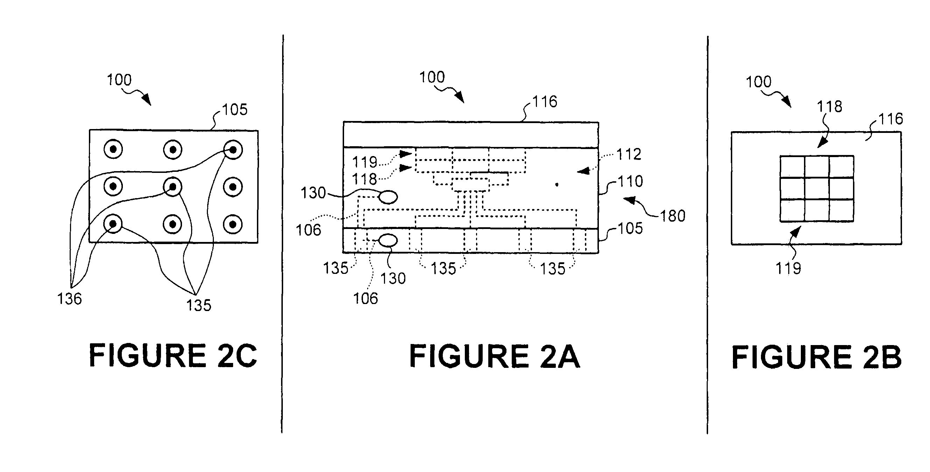

Figures 2A-5 illustrate a process for forming a coated wafer level camera module in accordance with selected embodiments of the invention. In certain embodiments, the coating on the module can provide at least partial shielding against selected types of electromagnetic energy.

Figure 2A is a partially schematic side view of a wafer level camera module 100 in accordance with embodiments of the present invention. In Figure 2A, the module 100 includes a die 110 having multiple image sensor integrated circuits 112. The image sensor integrated circuits 112 can include multiple pixels 118.

Micro lenses 119 can be positioned over the pixels 118 and carried by the die 110 (e.g.,the micro lenses 119 can be positioned over a light sensing element of the pixel 118 and over a color filter). In selected embodiments, an optic assembly 116 can cover at least a portion of the pixels 118 and/or the micro lenses 119. The optic assembly 116 can include any number of optical devices including clear cover sheets, clear cover layers, additional lenses, optical filters, and/or the like. Figure 2B is a partially schematic top view of the module shown in Figure 2A. In various embodiments, the die 110 can include other types of integrated circuits in addition to the image sensor integrated circuits 112. For the purposes of illustration, only nine pixels 118 are shown in Figure 2B. In other embodiments, the module 100 can include more or fewer pixels 118.

As shown in Figure 2A, the module 100 can also include multiple contacts 135 that are electrically coupled to the image sensor integrated circuits 112. In the illustrated embodiment, the module 100 includes an interposer 105 coupled to the die 110, for example, to form a chip scale package. In Figure 2A, the contacts 135 are positioned on the interposer 105 to facilitate electrically coupling the integrated circuits 112 to a support (e.g., a substrate, a printed circuit board, and/or a printed wiring board). The contacts 135 are also shown in Figure 2C which is a partially schematic bottom view of the module shown in Figure 2A. In selected embodiments, the contacts 135 can include solder balls 136 that are configured or suitable for use in coupling (e.g., electrically coupling) the contacts 135 on the module 100 to pads or contacts on a support during a reflow process. In other embodiments, other methods can be used to couple the contacts 135 to a support (e.g., without the use of the solder balls 136). For purposes of illustration, only nine contacts 135 are shown in Figure 2C. In other embodiments, the module 100 can include more or fewer contacts 135.

In certain embodiments, the module 100 shown in Figure 2A can also includes at least one grounding pad 130. In the illustrated embodiment, the module 100 includes two grounding pads 130, one on the die 110 and one on the interposer 105. In Figure 2A, both grounding pads are coupled to a contact 135 via connectors 106. In other embodiments, the module 100 can include more, fewer, and/or different grounding pads 130. Additionally, in other embodiments the grounding pad(s) 130 can be positioned on other portions and/or elements of the module 100. For example, in selected embodiments grounding pad(s) 130 are only located on the die 110 or only on the interposer 105. Furthermore, the grounding pad(s) 130 can be coupled to one or more contacts via other connectors 106 and/or via various portions of the integrated circuits carried by the die.

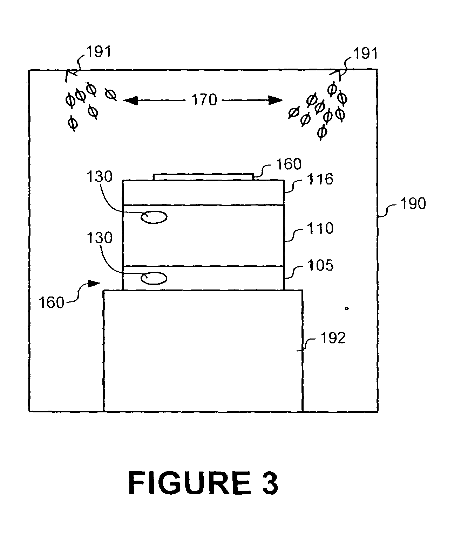

Figure 3 is a partially schematic illustration of the wafer level camera module 100 shown in Figure 2A positioned on a stand 192 in a chamber 190 to receive a coating in accordance with embodiments of the present invention. In the illustrated embodiment, a protective covering 160 has been applied to cover a portion of the optic assembly 116 and the contacts 135 (both of which are shown in Figures 2A-2C) in preparation for a coating process. The protective covering 160 can include any type of covering that can prevent, at least in part, the coating from adhering to a portion of the module 100 during the coating process. For example, applying a protective covering 160 can include affixing a tape, affixing a film, and/or positioning an object relative to a selected portion of the module 100 to prevent, at least in part, the selected portion from being coated. In Figure 3, a film has been affixed to the module 100 to cover a portion of the optic assembly 116, and the stand 192 has been positioned relative to the contacts 135 such that the contacts 135 will not be coated during the coating process. In other embodiments, the protective covering 160 does not touch the object(s) it covers. For example, in certain embodiments the module 100 can include pixels 118 and/or micro lenses 119 that are recessed through an aperture in a surface of the die 110 and the protective covering 160 can cover the pixels 118 and/or micro lenses 119 without touching the pixels 118 and/or micro lenses 119 by covering the aperture.

In the illustrated embodiment, a coating material 170 is being introduced into the chamber via inlets 191 to cover at least a portion of the module 100 with a coating (e.g., to cover at least a portion of the die 110). The coating material 170 can include a single material or a number of different materials or elements introduced simultaneously or sequentially (e.g., a combination of gases that will react with one another to form a coating on the module 100). The materials 170 can be in various states, including in the form of a fluid (e.g., a gas, vapor, and/or liquid) and/or a solid (e.g., a powder).

Additionally, various coating process can be used. For example, the coating process can include a vapor deposition process, a chemical deposition process, a film application process, a spray on application process, and/or an immersion process (e.g., the chamber can be filled with a coating material 170, immersing the module 100). In other embodiments, the coating can be applied without the use of a chamber 190 (e.g., when using selected spray-on processes and/or when the coating includes solid film strips that are applied to the module 100).

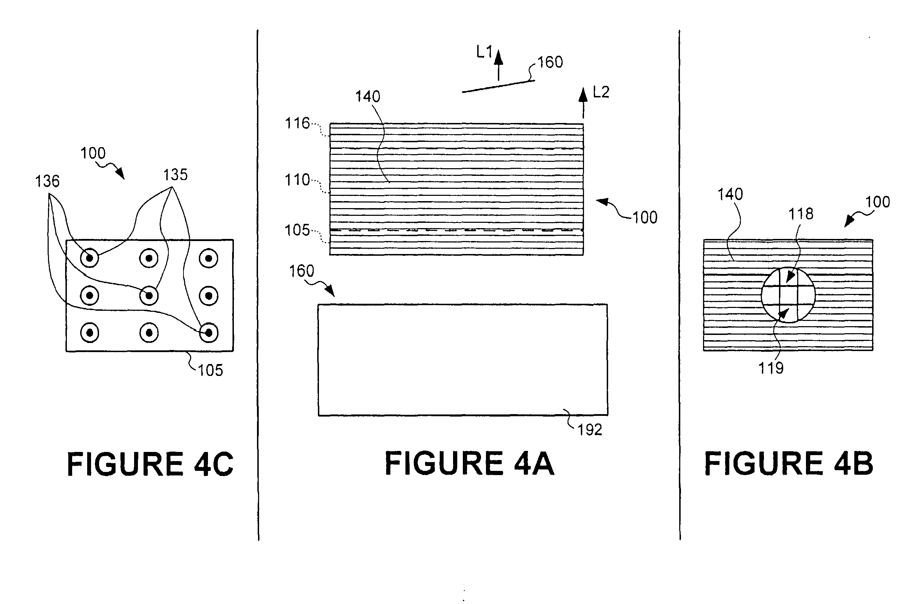

Figure 4A is a partially schematic side view of the module 100, shown in Figure 2A, after having received a coating 140 in accordance with embodiments of the present invention. In Figure 4A, the protective covering 160 has been removed from the module 100 as indicated by arrow L1, revealing an uncoated portion of the optic assembly 116 (shown in Figure 4B). Additionally, the protective covering 160 has been removed from the contacts 135 by removing the module 100 from the 192 as indicated by arrow L2, revealing the uncoated contacts (shown in Figure 4C).

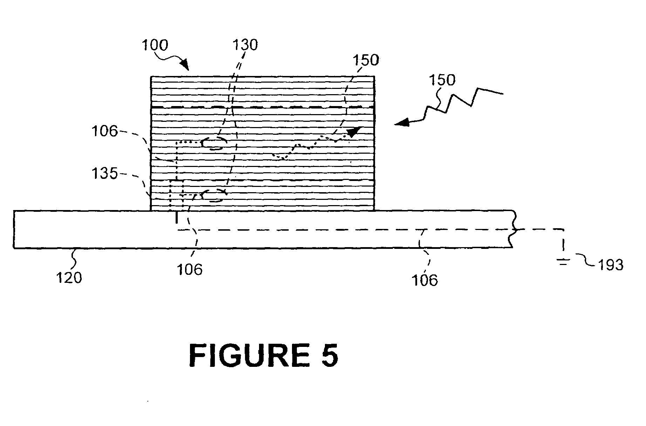

Figure 5 is a partially schematic illustration of the coated wafer level camera module 100, shown in Figure 4A, coupled to a support 120 (e.g., a substrate, printed circuit board, and/or printed wiring board) in accordance with embodiments of the present invention. The contacts 135 of the module 100 can be coupled to contacts on the support 120 via various processes (e.g., using a reflow process, using a ball grid array arrangement, using flip chip technology, using bonding wires, and/or the like). In the illustrated embodiment, the solder balls 136, shown in Figure 2C, have been used to electrically couple the grounding pad(s) 130 and/or the integrated circuits 112 of the module 100 to the support 120 (e.g., to pads or contacts on the support 120) using a reflow process. Additionally, in selected embodiments, other portions of the module 100 can be coupled to the support using adhesives and/or other coupling methods (e.g., clips).

In certain embodiments, the coating 140 can include a conductive coating that can be electrically coupled to the grounding pad(s) 130. For example, the coating 140 can include a metal, a conductive composite (e.g., a composite having metallic fibers and/or wires) and/or a conductive plastic (e.g., a plastic having a high concentration of conductive carbon). In the illustrated embodiment, the coating is conductive and has been applied so that it covers (e.g., adheres to) the grounding pad(s) 130, thereby electrically coupling the coating 140 to ground 193 via the grounding pad(s) 130, the connectors 106, the contact(s) 135, the support 120, and the connector 106 in the support. Accordingly, the coating 140 can provide at least a partial shield against selected types of electromagnetic energy 150 (e.g., electromagnetic radiation, electrical fields, and magnetic fields); thereby reducing the tendency for various types of electromagnetic energy 150 to enter and/or exit selected portions of the module 100.

For example, because the coating 140 is conductive and electrically coupled to the ground 193, electromagnetic energy 150 that cause induced currents in conductive materials can be at least partially blocked by the coating 140 (e.g., a portion of the electromagnetic energy 150 can be converted to a current flow in the coating 140, which is electrically coupled to the ground 193). In certain embodiments, the coating 140 can also be configured to block (e.g., deflect or absorb) selected frequencies of electromagnetic radiation. Accordingly, the coating 140 can provide at least a partial shield against the selected frequencies of electromagnetic radiation (e.g., visual and/or infrared light) entering and/or exiting one or more portions of the module 100. In other embodiments, the module 100 does not include grounding pads 130 and/or the coating 140 is not conductive, but the coating 140 is still configured to provide at least a partial shield against selected frequencies of electromagnetic radiation (e.g., frequencies falling in the light spectrum) entering and/or leaving one or more portions of the module 100. In still other embodiments, the coating 140 can be configured to block other types of electromagnetic energy (e.g., a radar reflective or absorbent material can be used to coat a portion of the module 100).

A feature of some of the embodiments described above is that wafer level camera modules can be coated during the module manufacturing process, providing at least some protection against selected types of electromagnetic energy. This feature can negate the need to install a metal box around the module when assembling a device that uses the module, while still providing a selected amount of protection against electromagnetic radiation interference and/or light interference. An advantage of this feature is that the production complexity and/or the cost of the device can be reduced, particularly when the modules can be coated in a batch process. Additionally, because the metal box is no longer required, the size and/or the weight of the device can be reduced.

Another feature of some of the embodiments discussed above is that the coating can be used to block selected frequencies of light from entering various portions of the wafer level camera module. For example, as shown in Figure 4B the coating can be used to create a small area through which light can enter the module 100 (e.g., through the optic assembly), but can generally prevent light from entering other portions of the module 100. This can negate the need for placing a housing around the module 100 during the production process, thereby reducing complexity, size, weight, and/or cost over that of current systems.

In other embodiments, the wafer level camera module 100 can have other arrangements. For example, in selected embodiments the grounding pad(s) 130 are only located on the die 110 or the interposer 105, but is/are electrically coupled to a conductive coating 140 covering portions of both the die 110, the interposer 105, and the optic assembly 116. In other embodiments, the module 100 does not include an interposer. For instance, in selected embodiments the contacts 135 are positioned on the die 110, and the die 110 (with the contacts 135) is configured to be coupled directly to the support 120 (e.g., using direct chip attach technology).

The coating process can also include various other arrangements. For example, in other embodiments the protective coating(s) 160 can be applied to more, fewer, and/or other portions of the module 100 prior to the coating process. For instance, in certain embodiments the module 100 does not include an optic assembly 116 and the protective covering 160 is positioned to cover an aperture associated with recessed image sensor integrated circuits 112, the micro lenses of the pixels 118, and/or other optical devices (e.g., lens(es)) associated with the image sensor integrated circuits 112. In still other embodiments, the protective coverings 160 are not required/used during the application of the coating 140 because one or more shaped pieces of film or tape are precisely applied to selected locations on the module 100 or because the entire module 100 is coated. In certain embodiments, the covering 160 can be applied to the die 110 (e.g., a die 110 with or without grounding pad(s) 130) and the die 110 can then be mounted onto an interposer 105.

In yet other embodiments, the protective cover 160 can actually be a first coating applied to selected portions of the module 100. For example, prior to the coating process described above with reference to Figure 3 (e.g., the process of applying a conductive coating to the module) a protective covering 160 in the form of a first coating can be applied to a selected area of the module (e.g., sprayed onto a portion of the optic assembly 116). A second coating (e.g., the application of the conductive coating) can then be applied during the coating process described above with reference to Figure 3. The first coating can prevent the second coating from adhering to the selected area. In certain embodiments, the first coating can then be removed after the second coating is applied, for example, by a solvent that will remove the first coating and/or a combination of the first and second coatings, but will not remove the first coating by itself. These additional embodiments discussed above can have features and advantages similar to those discussed above with reference to Figures 2A-5.

From the foregoing, it will be appreciated that specific embodiments of the invention have been described herein for purposes of illustration, but that various modifications may be made without deviating from the invention. Accordingly, the invention is not limited except as by the appended claims.

## Claims

1. A wafer level camera module, comprising:
a die having multiple image sensor integrated circuits;
at least one grounding pad;
a conductive coating covering at least a portion of the die, the coating being electrically coupled to the at least one grounding pad; and
multiple contacts positioned to electrically couple the integrated circuits and the at least one grounding pad to a support.

2. The module of claim 1 wherein the die carries a micro lens.

3. The module of claim 1 further comprising an optic assembly carried by the die, wherein the conductive coating covers at least a portion of the optic assembly.

4. The module of claim 1 wherein the conductive coating includes at least one of a metal, a conductive composite, and a conductive plastic.

5. The module of claim 1 wherein the conductive coating covers the at least one grounding pad.

6. The module of claim 1 wherein the conductive coating is configured to provide at least a partial shield against selected types of electromagnetic energy when the at least one grounding pad is electrically coupled to the support.

7. The module of claim 1 wherein the coating is configured to provide at least a partial shield against one or more selected frequencies of light.

8. The module of claim 1, further comprising an interposer wherein the multiple contacts are positioned on the interposer, and wherein the die is coupled to the interposer to form a chip scale package.

9. The module of claim 1, further comprising an interposer wherein:
the multiple contacts are positioned on the interposer;
the contacts include solder balls suitable for use in a reflow process; and
the die is coupled to the interposer to form a chip scale package.

10. The module of claim 1, further comprising an interposer wherein:
the multiple contacts are positioned on the interposer;
the die is coupled to the interposer to form a chip scale package; and
at least a portion of the coating covers the interposer.

11. A wafer level camera module, comprising:
a die having multiple image sensor integrated circuits;
a coating covering at least a portion of the die, the coating being configured to provide at least a partial shield against selected types of electromagnetic energy; and
multiple contacts positioned to electrically couple the integrated circuits to a support.

12. The module of claim 11 wherein the selected types of electromagnetic energy include one or more selected frequencies of light.

13. The module of claim 11, further comprising an optic assembly carried by the die, wherein the coating covers at least a portion of the optic assembly.

14. A method for making a coated wafer level camera module, comprising:
providing a wafer level camera module having a die with multiple image sensor integrated circuits, at least one grounding pad, and multiple contacts positioned to electrically couple the integrated circuits and the at least one grounding pad to a support; and
applying a conductive coating to at least a portion of the die, the coating being electrically coupled to the at least one grounding pad.

15. The method of claim 14 wherein providing a wafer level camera module includes providing a wafer level camera module that includes an optic assembly and wherein applying a conductive coating includes applying a conductive coating to at least a portion of the optic assembly.

16. The method of claim 14 wherein applying a conductive coating includes applying a coating that is configured to provide at least a partial shield against selected types of electromagnetic energy when the at least one grounding pad is electrically coupled to the support.

17. The method of claim 14 wherein applying a conducive coating includes applying a coating that is configured to provide at least a partial shield against one or more selected frequencies of light.

18. The method of claim 14 wherein providing a wafer level camera module includes providing a wafer level camera module having a die coupled to an interposer to form a chip scale package, and wherein the multiple contacts are positioned on the interposer.

19. The method of claim 14 wherein applying a coating includes at least one of a vapor deposition process, a chemical deposition process, a film application process, an immersion process, and a spray-on application process.

20. The method of claim 14 wherein the method further comprises applying at least one protective covering to cover at least a portion of the wafer level camera module before applying the conductive coating.
